(19) Europäisches Patentamt
European Patent Office
Office européen des brevets

(11) **EP 1 812 957 B1**

(12) **EUROPÄISCHE PATENTSCHRIFT**

(45) Veröffentlichungstag und Bekanntmachung des Hinweises auf die Patenterteilung:
**02.03.2011 Patentblatt 2011/09**

(21) Anmeldenummer: 05807468.3

(22) Anmeldetag: **12.11.2005**

(51) Int Cl.:
**H01L 21/00** (2006.01)

(86) Internationale Anmeldenummer:
**PCT/EP2005/012143**

(87) Internationale Veröffentlichungsnummer:
**WO 2006/053690 (26.05.2006 Gazette 2006/21)**

(54) **VERFAHREN UND VORRICHTUNG ZUM THERMISCHEN BEHANDELN VON SUBSTRATEN**

METHOD AND DEVICE FOR THERMALLY TREATING SUBSTRATES

PROCEDE ET DISPOSITIF DE TRAITEMENT THERMIQUES DES SUBSTRATS

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **17.11.2004 DE 102004055449**

(43) Veröffentlichungstag der Anmeldung:
**01.08.2007 Patentblatt 2007/31**

(73) Patentinhaber: **HamaTech APE GmbH & Co. KG**
**75447 Sternenfels (DE)**

(72) Erfinder:
• **SAULE, Werner**
**75015 Bretten (DE)**
• **BERGER, Lothar**
**01099 Dresden (DE)**
• **KRAUSS, Christian**
**72810 Gomaringen (DE)**
• **WEIHING, Robert**
**75417 Mühlacker (DE)**

(74) Vertreter: **Wagner & Geyer**
**Partnerschaft**
**Patent- und Rechtsanwälte**
**Gewürzmühlstrasse 5**
**80538 München (DE)**

(56) Entgegenhaltungen:
EP-A- 0 418 541    DE-C1- 10 059 665
US-A- 5 996 353

**Beschreibung**

Die vorliegende Erfindung bezieht sich auf ein Verfahren und eine Vorrichtung zum thermischen Behandeln von Substraten, insbesondere flachen Substraten in der Halbleiterherstellung.

Bei der Herstellung von Bauelementen im Bereich der Halbleiterindustrie ist es bekannt, Substrate in einer Heizvorrichtung thermisch zu behandeln, wie es beispielsweise aus der auf die Anmelderin der vorliegenden Anmeldung zurückgehenden DE 100 59 665 C1 oder der ebenfalls auf die Anmelderin zurückgehenden DE 199 07 497 C bekannt ist. Ein üblicher Prozessschritt ist beispielsweise das Aushärten eines Lacks nach einer Belackung sowie das so genannte "Post-exposure Bake" (PEB) zur Fixierung von "Chemically Amplified Resists" (CAR) nach einer Belichtung. Für die Qualität der Strukturen sowie das Ergebnis der thermischen Behandlung ist eine gleichmäßige homogene Wärmezufuhr in das Substrat, insbesondere in eine darauf befindliche Schicht von entscheidender Bedeutung. Dies ist insbesondere bei eckigen Substraten mit hoher Materialstärke, wie beispielsweise Fotomasken, nicht ohne weiteres möglich, da während des Aufheizens des Substrats im Zentrum relativ zu den Kanten mehr Masse aufzuheizen ist und sich das Zentrum relativ zu den Kanten daher langsamer erwärmt. Andererseits strahlen die Kanten nach Erreichen einer Endtemperatur aufgrund der größeren Oberfläche relativ zum Zentrum mehr Wärme ab, so dass sie nach Erreichen der Endtemperatur schneller abkühlen. Dieselbe Problematik besteht natürlich auch bei runden Halbleitersubstraten.

Um dieses Problem zu überwinden, wurde in der Vergangenheit eine Heizvorrichtung mit mehreren aktiv geregelten Zonen eingesetzt, wie es aus der oben genannten DE 199 07 497 C bekannt ist, sowie ein selbstoptimierendes Steuerverfahren gemäß der DE 100 59 665 C1. Durch diese Heizvorrichtungen war es möglich, das Zentrum eines Substrats während der Aufheizphase relativ zu den Kanten stärker zu heizen und nach Erreichen der Endtemperatur wiederum die Kanten relativ zum Zentrum stärker zu heizen.

Obwohl die bekannte Vorrichtung und das bekannte Steuerungsverfahren gute Ergebnisse bringen, besteht immer noch das Bedürfnis, die Temperaturhomogenität bei thermischen Behandlungen noch weiter zu erhöhen, insbesondere für Fotomasken der nächsten Generation (65 nm Node).

Ausgehend von dem bekannten Stand der Technik liegt der vorliegenden Erfindung daher die Aufgabe zugrunde, ein Verfahren und eine Vorrichtung zum thermischen Behandeln von Substraten vorzusehen, mit dem bzw. mit der eine verbesserte Homogenität einer thermischen Behandlung erreicht werden kann.

Erfindungsgemäß wird diese Aufgabe bei einem Verfahren zum thermischen Behandeln von Substraten, bei dem die Substrate in Kontakt mit oder eng beabstandet zu einer Heizplatte gehalten werden, die über eine Vielzahl von separat ansteuerbaren Heizelementen auf der vom Substrat abgewandten Seite der Heizplatte erwärmt wird dadurch gelöst, dass die Heizplatte wenigstens in ihrer Ebene, d.h. radial von einem hierzu beabstandeten Rahmen umgeben ist, und Gas durch einen Spalt zwischen dem Rahmen und wenigstens einer Kante der Heizplatte geleitet wird, wobei das Gas derart geleitet wird, dass es nicht in Kontakt mit dem Substrat gelangt, und wobei die Durchflussmenge und/oder die Temperatur des Gases gesteuert wird, um die Temperatur der Kante der Heizplatte zu beeinflussen. Durch die Erzeugung eines Spaltes zwischen einem Rahmen und einer Heizplatte sowie das gesteuerte Leiten von Gas durch diesen Spalt, ist eine aktive Kühlung von Randbereichen der Heizplatte möglich, um hierüber eine verbesserte Homogenität einer thermischen Behandlung eines Substrats zu ermöglichen. Das gesteuerte Hindurchleiten von Gas durch einen Spalt ermöglicht zusätzlich zu anderen Steuerparametern eine gezielte Abkühlung eines Randbereichs einer Heizplatte, um beispielsweise während einer Aufheizphase relativ zum Zentrum das Substrat weniger zu heizen. Die aktive Kühlung ermöglicht eine schnelle Änderung, insbesondere Verringerung der Temperatur des Randbereichs der Heizplatte.

Eine Verringerung der Temperatur im Randbereich der Heizplatte ist wesentlich schneller zu erreichen als dies beispielsweise durch eine Verringerung der Energiezufuhr an eines der Heizelemente im Randbereich erreicht werden könnte.

Das erfindungsgemäße Verfahren ermöglicht somit eine thermische Behandlung von Substraten bei verbesserter Temperaturhomogenität.

Gemäß einer bevorzugten Ausführungsform der Erfindung wird die Breite des Spalts entlang wenigstens eines Teilbereichs einer Kante der Heizplatte vor und/oder während einer thermischen Behandlung eines Substrats verändert, um die Strömungsverhältnisse im Bereich des Spalts einzustellen, und somit die Kühlung in diesem Bereich zu verändern. Hierdurch lässt sich beispielsweise eine gezielte asymmetrische Kühlung von Randbereichen der Heizplatte erreichen, um Asymmetrien im Heizverhalten der Heizvorrichtung auszugleichen. Dabei wird die Breite lokal vorzugsweise in einem Bereich zwischen 0 und 5 mm, insbesondere zwischen 1 und 5 mm verändert.

Für eine gute Führung des Gases wird es vorzugsweise vor dem Eintritt in den Spalt an einem Umlenkelement umgelenkt, um eine gezielte Kühlung im Bereich der Kante einer Heizplatte vorzusehen. Bei einer besonders bevorzugten Ausführungsform der Erfindung ist das Gas Umgebungsluft. Dadurch dass Umgebungsluft durch den Spalt gelenkt wird, ergibt sich ein besonders einfacher Aufbau der Vorrichtung. Da das obige Verfahren üblicherweise in Reinsträumen erfolgt, in denen klimatisierte Luft vorgesehen ist, lässt sich mit der Umgebungsluft eine gute und gleichmäßige Kühlung erreichen, da die Temperatur der Umgebungsluft in der Regel bekannt und gleichbleibend ist.

Bei einer alternativen Ausführungsform ist das Gas ein Kühlgas, das in einem im Wesentlichen geschlossenen Kühlkreis zirkuliert. Die Verwendung eines Kühlgases, das auch Luft sein kann, und das in einem im Wesentlichen geschlossenen Kühlkreis zirkuliert ermöglicht nicht nur die Durchflussmenge von Gas durch den Spalt sondern auch die Temperatur des Gases zu steuern, wodurch sich die Kühlung im Randbereich der Heizplatte noch besser steuern lässt.

Vorteilhafterweise wird die durch den Spalt geleitete Gasmenge, die Spaltbreite und/oder die Temperatur des Gases anhand eines vor der thermischen Behandlung ermittelten Profils gesteuert, um bei unterschiedlichen Prozessabschnitten eine jeweils vorbestimmte Kühlung eines Randbereichs der Heizplatte vorzusehen.

Bei einer weiteren Ausführungsform der Erfindung wird die Temperatur auf der von der Heizplatte abgewandten Seite des Substrats ortsauflösend gemessen und das vor der thermischen Behandlung ermittelte Profil für die durch den Spalt geleitete Gasmenge, die Spaltbreite und/oder die Temperatur des Gases in Abhängigkeit von der gemessenen Temperaturverteilung auf dem Substrat verändert, wenn Temperaturunterschiede zwischen unterschiedlichen Ortspunkten auf der Oberfläche des Substrats einen Schwellenwert übersteigen. Hierdurch ist eine rasche Steuerung bzw. Regelung der Temperatur eines Randbereichs einer Heizplatte in Abhängigkeit von einer Temperaturverteilung auf dem Substrat möglich. Dabei wird vorzugsweise ein während einer thermischen Behandlung verändertes Profil für die durch den Spalt geleitete Gasmenge, die Spaltbreite und/oder die Temperatur des Gases gespeichert, und für eine nachfolgende Behandlung als neu ermitteltes Profil verwendet, um eine vorausschauende Steuerung und Selbstoptimierung des vorgegebenen Profils zu ermöglichen.

Alternativ oder zusätzlich erfolgt vorzugsweise ein ortsausgelöstes Messen der Temperatur auf der von der Heizplatte abgewandten Seite des Substrats, das Messen der Temperatur jedes Heizelements und das Regeln der Temperatur jedes Heizelements mit einem PID-Regelalgorithmus, in den die gemessene Temperatur des Heizelements als Ist-Wert eingeht; und wobei ein vor der thermischen Behandlung ermitteltes Sollwertprofil der Temperatur für den PID-Regelalgorithmus in Abhängigkeit von der gemessenen Temperatur auf dem Substrat verändert wird, wenn Temperaturunterschiede zwischen unterschiedlichen Ortspunkten auf der Oberfläche des Substrats einen Schwellenwert übersteigen.

Um eine selbstoptimierende Prozesssteuerung vorzusehen, wird vorzugsweise ein während einer thermischen Behandlung verändertes Sollwertprofil gespeichert und für eine nachfolgende Behandlung als neues, ermitteltes Sollwertprofil verwendet.

Gemäß einer weitere Ausführungsform der vorliegenden Erfindung wird eine Strukturbreite, insbesondere eine Lackstrukturbreite auf einer Oberfläche eines Substrats nach einer thermischen Behandlung ortsauflösend gemessen, und anhand der Messung ein ortsaufgelöstes Temperaturprofil während der thermischen Behandlung auf der Oberfläche des Substrats berechnet, wobei die durch den Spalt geleitete Gasmenge, die Spaltbreite und/oder die Temperatur des Gases in Abhängigkeit vom berechneten Temperaturprofil auf dem Substrat für einen nachfolgenden thermischen Behandlungsvorgang eingestellt wird. Hierdurch ist wiederum eine Selbstoptimierung des Prozesses möglich, da die in einem vorhergehenden Behandlungsprozess aufgetretenen Inhomogenitäten durch Veränderung eines Ansteuerprofils bei einer nachfolgenden Behandlung berücksichtigt werden können.

Die der Erfindung zugrunde liegende Aufgabe wird auch bei einer Vorrichtung zum thermischen Behandeln von Substraten gelöst, die eine Heizplatte, Mittel zum Halten eines Substrats in Kontakt mit oder eng beabstandet zu der Heizplatte, eine Vielzahl von separat ansteuerbaren Heizelementen auf der vom Substrat abgewandten Seite der Heizplatte, einen Rahmen der die Heizplatte in ihrer Ebene, d.h. radial umgibt, wobei der Rahmen zur Heizplatte beabstandet ist und wenigstens einen Spalt zwischen dem Rahmen und wenigstens einer Kante der Heizplatte bildet, und wenigstens eine Einrichtung zum Leiten von Gas durch den Spalt aufweist, wobei die Einrichtung die Durchflussmenge und/oder die Temperatur des durch den Spalt geleiteten Gases steuert, und wobei Mittel zum Leiten des Gases derart, dass es nicht in Kontakt mit dem Substrat gelangt, vorgesehen sind. Die obige Vorrichtung ermöglicht wiederum eine rasche ansprechende Temperatursteuerung eines Randbereichs einer Heizplatte, in dem steuerbar Gas durch einen Spalt zwischen einer Kante einer Heizplatte und einem Rahmen geleitet wird.

Um die Kühlung individueller Randbereiche steuern zu können, ist vorzugsweise wenigstens ein verstellbar am Rahmen angebrachtes Element zum lokalen Einstellen der Breite des Spaltes vorgesehen. Hierdurch lässt sich das Kühlprofil einstellen, und zwar insbesondere auch ein asymmetrisches Kühlprofil entlang wenigstens einer Kante der Heizplatte, um einer asymmetrische Aufheizung der Heizplatte entgegenzuwirken. Dabei ist der Spalt lokal vorzugsweise zwischen 0 und 5 mm, insbesondere zwischen 1 und 5 mm, verstellbar.

Gemäß einer bevorzugten Ausführungsform der Erfindung ist eine Vielzahl von Elementen entlang einer Kante der Heizplatte vorgesehen, um entlang der Kante unterschiedliche Kühlprofile vorzusehen. Dabei ist eine zur Heizplatte weisende Kontur des Elements vorzugsweise komplementär zu einer Kontur der ihm gegenüber liegenden Kante der Heizplatte, um im Bereich eines jeweiligen Elements einen im Wesentlichen gleichbleibenden Spalt zu erzeugen.

Für einen einfachen Aufbau der vorliegenden Erfindung besitzt der Rahmen vorzugsweise eine Bodenwand und wenigstens eine Seitenwand, wobei die wenigstens eine Seitenwand die Heizplatte radial umgibt, wobei oberhalb der Bodenwand ein Strömungsraum gebildet wird, der mit dem Spalt in Verbindung steht, und wobei die steuerbare Einrichtung zum Leiten von Gas durch den Spalt mit einer Öffnung in der Bodenwand des Rahmens in Verbindung steht. Hierdurch kann auf einfache Weise über einen unterhalb der Heizplatte gebildeten Strömungsraum Luft durch den Spalt gesaugt bzw. durch diesen gedrückt werden, wobei ein Raum zwischen der Bodenwand des Rahmens und der Heizplatte als Verteilungsraum dienen kann, der ein gleichmäßiges Ansaugen bzw. Ausblasen von Luft durch den Spalt ermöglicht.

Vorzugsweise ist ein Umlenkelement vorgesehen, das die Heizplatte in einem Randbereich auf ihrer Oberseite kontaktiert und an einem Ende des Spalts einen Strömungskanal bildet. Hierdurch wird eine kontrollierte Leitung von Gas durch den Spalt und eine kontrollierte Abkühlung der Heizplatte an ihrem Randbereich gefördert.

Für einen einfachen Aufbau der Vorrichtung steht der Spalt mit Umgebungsluft in Verbindung, so dass Umgebungsluft zur Kühlung durch den Spalt geleitet werden kann. Um eine noch bessere Kühlung bzw. Steuerung der Kühlung zu erreichen, ist der Spalt bei einer alternativen Ausführungsform Teil eines im Wesentlichen geschlossenen Strömungskreislaufs, in dem eine Kühl- und/oder Heizvorrichtung angeordnet ist.

Vorzugsweise ist eine auf die von der Heizplatte abgewandte Oberfläche des Substrats gerichtete, ortsauflösende Temperaturmessvorrichtung und eine Prozesssteuereinheit, die mit der Temperaturmessvorrichtung und der steuerbaren Einrichtung zum Leiten von Gas durch den Spalt in Verbindung steht, vorgesehen, um die Temperaturverteilung auf der Substratoberfläche zu ermitteln, und die steuerbare Einrichtung zum Leiten von Gas durch den Spalt anhand der Temperaturverteilung zu steuern. Dies ermöglicht eine Anpassung der Kühlung an eine Temperaturverteilung auf einer Substratoberfläche während eines thermischen Behandlungsprozesses.

Für eine gute Steuerung der einzelnen Heizelemente ist vorzugsweise jedem Heizelement ein Temperatursensor zugeordnet, um dessen Temperatur zu messen, und ferner ist wenigstens ein PID-Regler vorgesehen, der mit den Heizelementen und dem zugeordneten Temperatursensor verbunden ist, um eine Temperaturregelung der einzelnen Heizelemente während einer thermischen Behandlung zu ermöglichen. Dabei ist vorzugsweise für jedes Heizelement ein PID-Regler vorgesehen, um einen stetige Echtzeitregelung zu gewährleisten. Wenn nur ein einziger PID-Regler vorgesehen ist, könnte dieser beispielsweise sequentiell die einzelnen Heizelemente regeln, wodurch jedoch eine Regelung des Heizelements während zeitlich beabstandeter Intervalle möglich ist.

Vorzugsweise steht die Prozesssteuereinheit mit dem/den PID-Regler(n) in Verbindung und ermittelt in Abhängigkeit von der Temperaturverteilung auf der Substratoberfläche Temperatur-Sollwerte für die einzelnen Heizelemente und übermittelt diese an den/die PID-Regler. Hierdurch wird ein äußerer Eingriff und eine Anpassung der Temperatur-Sollwerte für die einzelnen PID-Regler auf der Grundlage einer Temperaturverteilung auf der Substratoberfläche ermöglicht, wodurch die Regelung der Temperaturhomogenität verbessert werden kann.

Gemäß einer besonders bevorzugten Ausführungsform der Erfindung ist die steuerbare Einrichtung zum Leiten von Gas durch den Spalt zentriert unterhalb der Heizplatte angeordnet, um bezüglich der Seitenkante(n) zu der Heizplatte ein gleichmäßiges Hindurchleiten von Gas zu fördern. Dabei ist die steuerbare Einrichtung zum Leiten von Gas durch den Spalt vorzugsweise eine Absaugeinrichtung, die beispielsweise Umgebungsluft durch den Spalt hindurchsaugt.

Bei einer besonders bevorzugten Ausführungsform der Erfindung weist die steuerbare Einrichtung zum Leiten von Gas durch den Spalt eine Steuereinheit auf, um die durch den Spalt geleitete Gasmenge und/oder die Temperatur des Gases einzustellen.

Die vorliegende Erfindung wird nachfolgend anhand der Zeichnungen näher erläutert; in den Zeichnungen zeigt:

Fig. 1    eine schematische Draufsicht auf eine Heizvorrichtung der vorliegen- den Erfindung, wobei zur Vereinfachung der Darstellung gewisse E- lemente weggelassen wurden;

Fig. 2    eine schematische Querschnittansicht der Vorrichtung gemäß Fig. 1;

Fig. 3    eine schematische Schnittansicht einer alternativen Ausführungsform einer Heizvorrichtung gemäß der vorliegenden Erfindung entlang der Linie III-III in

Fig. 4    eine schematische Querschnittansicht der Vorrichtung gemäß Fig. 3;

Fig. 5    eine graphische Darstellung der Durchschnittstemperatur auf einer Oberfläche des Substrats während einer thermischen Behandlung gemäß der vorliegenden Erfindung und gemäß einem Vergleichsver- fahren;

Fig. 6    eine graphische Darstellung örtlicher Temperaturabweichungen auf einer Substratoberfläche bei einer thermischen Behandlung gemäß der vorliegenden Erfindung im Vergleich zu einer thermischen Be- handlung gemäß einem Vergleichsverfahren;

Fig. 7    eine Darstellung des Regelkreises zur automatischen Optimierung eines Heizprogramms;

Fig. 8    eine alternative Darstellung eines Regelkreises zur automatischen Optimierung eines Heizprogramms unter Berücksichtigung von Lack- strukturbreiten auf dem Substrat;

Fig. 9    eine graphische Darstellung eines optimierten Heizprogramms ge- mäß der vorliegenden Erfindung;

Fig. 10 eine schematische Draufsicht auf eine alternative Heizvorrichtung der vorliegenden Erfindung;

Fig. 11 eine schematische Draufsicht auf die Heizvorrichtung gemäß Fig. 10, wobei verstellbare Elemente der Vorrichtung in einer unterschiedli- chen Position gezeigt sind;

Fig. 12 eine weitere schematische Draufsicht auf die Heizvorrichtung gemäß Fig. 10, wobei wiederum verstellbare Elemente der Vorrichtung in un- terschiedlichen Positionen dargestellt sind. ^

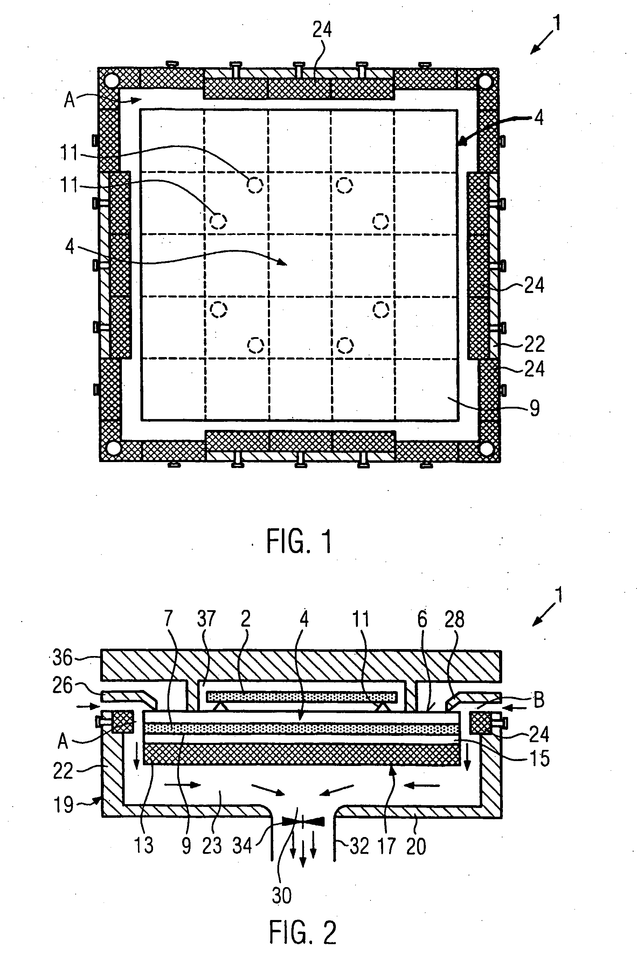

Die Figuren 1 und 2 zeigen eine schematische Draufsicht auf eine Vorrichtung 1 zum Behandeln von Substraten 2 bzw. eine Querschnittsansicht derselben, gemäß einem ersten Ausführungsbeispiel der Erfindung. In der Draufsicht gemäß Figur 1 sind bestimmte Elemente zur Verdeutlichung der vorliegenden Erfindung weggelassen, die in Figur 2 jedoch zu erkennen sind.

Die Vorrichtung 1 besitzt eine ebene, in Draufsicht quadratische Heizplatte 4 mit einer Oberseite 6 und einer Rückseite 7. An der Rückseite 7 sind Heizelemente 9 angebracht, wobei wie in der Draufsicht gemäß Figur 1 angedeutet ist, insgesamt 25 Heizelemente 9 vorgesehen sind. In bzw. auf der Heizplatte sind Auflageelemente 11 vorgesehen, die entweder feststehend oder höhenverstellbar sind, um ein darauf aufliegendes Substrat 2 anzuheben bzw. abzusenken. Wie in der Draufsicht gemäß Figur 1 zu erkennen ist, sind bei dem dargestellten Ausführungsbeispiel insgesamt 8 Auflageelemente 11 vorgesehen, obwohl natürlich auch eine hiervon abweichende Anzahl vorgesehen werden kann.

Wie in der Schnittansicht gemäß Figur 2 zu erkennen ist, ist unterhalb der Heizelemente 9 eine Isolierplatte 13 vorgesehen, die über einen schmalen Luftspalt 15 zu den Heizelementen beabstandet ist. Der Luftspalt 15 dient als Zuführungsraum für elektrische Leitungen etc. zur Ansteuerung der Heizelemente 9. Alternativ könnte das Isolierelement 13 jedoch auch direkt in Kontakt mit der Rückseite der Heizelemente 9 stehen, sofern in dem Isolierelement entsprechende Zuleitungen ausgebildet sind. Jedem Heizelement ist ferner ein Temperatursensor zugeordnet, der beispielsweise an einer Rückseite jedes Heizelements befestigt ist.

Die Heizplatte 4, die Heizelemente 9 und das Isolierelement 13 sind in bekannter Weise miteinander verbunden, um eine Heizplatteneinheit 17 zu bilden. Die Heizplatteneinheit 17 ist innerhalb eines äußeren Rahmenelements 19 aufgenommen und wird darinnen durch nicht dargestellte Halteelemente getragen. Das Rahmenelement 19 besteht im Wesentlichen aus einer Bodenwand 20 sowie entsprechenden Seitenwänden 22. Bei der dargestellten Ausführungsform sind vier Seitenwände 22 vorgesehen, die einen quadratischen Rahmen bilden. An einem oberen Ende der Seitenwände 22 sind jeweils insgesamt fünf in Horizontalrichtung verstellbare Elemente 24 vorgesehen, deren Funktion nachfolgend noch näher erläutert wird.

Die Heizplatteneinheit 17 ist zentriert innerhalb des Rahmenelements 19 angeordnet, wobei die verstellbaren Elemente 24 auf der Höhe der Heizplatte 4 mit den darunter liegenden Heizelementen 9 liegen.

Die Seitenwände 22 mit den verstellbaren Elementen 24 umgeben das Heizplattenelement 17 in Radialrichtung, und zwar derart, dass zwischen der Heizplatteneinheit 17 und den Seitenwänden 22 ein Spalt A gebildet wird. Durch die verstellbaren Elemente 24 lässt sich die Spaltbreite des Spalts A lokal in einem Bereich zwischen 0 mm und 5 mm verändern, d.h. der Spalt ist lokal vollständig schließbar wenn entlang eines Kantenbereichs keine Kühlung vorgesehen werden soll. Dabei ist dass schließen des Spalts aber nur in lokalen Abschnitten vorgesehen Vorzugsweise erfolgt eine Einstellung der Spaltbreite jedoch in einem Bereich von 1 bis 5 mm, wie nachfolgend noch näher erläutert wird. Eine Voreinstellung der Elemente 24 ist dabei so gewählt, dass der Spalt A im Bereich der Ecken der quadratischen Heizplatte größer ist als in den übrigen Bereichen, wie in der Draufsicht gemäß Fig. 1 zu erkennen ist. Ferner wird zwischen der Bodenwand 22 des Rahmenelements und der Unterseite der Heizplatteneinheit ein Strömungsraum 23 gebildet, der sich an den Spalt A anschließt.

Als Teil des Rahmens ist ein Umlenkelement 26 vorgesehen, das die Heizplatte 4 auf ihrer Oberseite 6 kontaktiert. Zwischen dem Umlenkelement 26 und einer Oberseite der Seitenwand 22 ist eine Strömungsöffnung B vorgesehen. Durch einen schrägen Abschnitt 28 des Umlenkelements 26 wird eine durch die Strömungsöffnung B eintretende Luftströmung in Richtung des Spalts A umgelenkt bzw. wird eine durch den Spalt A nach oben austretende Luftströmung radial nach außen umgelenkt. Natürlich kann das Umlenkelement 26 auch separat vom Rahmen 18 vorgesehen werden. Das Umlenkelement bewirkt, dass die durch den Spalt strömende Luft nicht in Kontakt mit dem zu behandelnden Substrat gelangt.

Die Bodenwand 20 des Rahmenelements 19 besitzt eine zentrierte Mittelöffnung 30, an die sich ein Absaugrohr 32 anschließt. Im Bereich des Absaugrohrs 32 ist ein regelbarer Lüfter 34 vorgesehen, um Gas, vorzugsweise Umgebungsluft durch die Strömungsöffnung B den Spalt A und den Strömungsraum 23 anzusaugen und durch das Absaugrohr auszustoßen.

Wie in Figur 2 zu erkennen ist, weist die Vorrichtung 1 ferner einen Deckel 36 auf, der im geschlossenen Zustand die Oberseite der Heizplatte kontaktiert und einen Aufnahmeraum 37 für das Substrat 2 bildet. Der Deckel 36 ist in geeigneter Weise relativ zu dem Rahmenelement 22 und der Heizplatteneinheit 17 bewegbar, um einen im Wesentlichen geschlossenen Aufnahmeraum 37 zwischen der Oberseite 6 der Heizplatte 4 und dem Deckel 36 zu bilden. Am Deckel 36 ist eine nicht näher dargestellte Temperaturmessvorrichtung vorgesehen, die eine ortsaufgelöste Temperaturmessung auf einer Oberseite des Substrats 2 vornimmt. Die Ergebnisse einer derartigen Temperaturmessung werden einer nicht näher dargestellten Steuervorrichtung zugeführt.

Nachfolgend wird der Betrieb der Heizvorrichtung 1 gemäß den Figuren 1 und 2 näher erläutert.

Zunächst wird bei geöffnetem Deckel 36 ein Substrat 2 auf den Auflageelementen 11 abgelegt. Anschließend wird der Deckel 36 geschlossen, um den im Wesentlichen geschlossenen Aufnahmeraum 37 zubilden, wie in Figur 2 dargestellt ist.

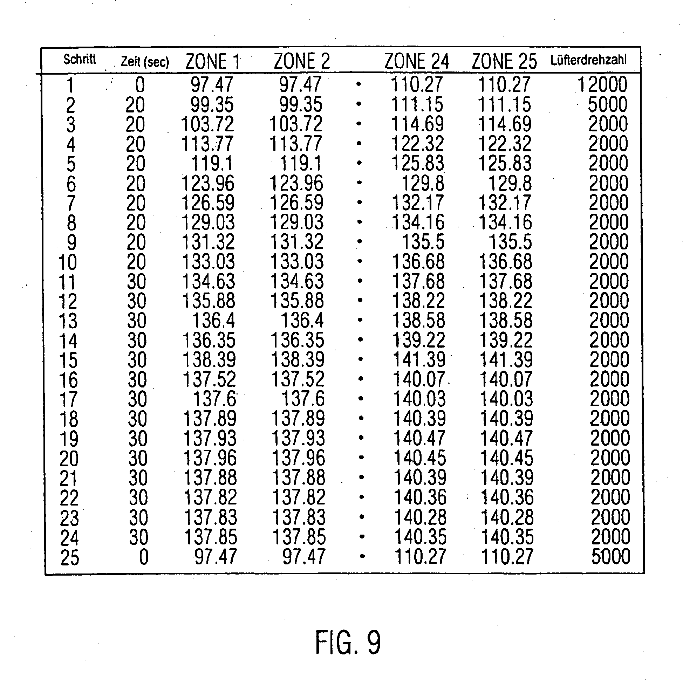

Anschließend werden die Heizelemente 9 gemäß einem vorgegebenen Heizprofil und der Lüfter gemäß einem vorgegebenen Lüfterprofil angesteuert, die beispielsweise während eines Kalibrierprozesses für den gewünschten thermischen Behandlungsprozess ermittelt wurden. Ein entsprechendes Prozessprogramm, mit Heiz- bzw. Lüfterprofilen ist schematisch in Figur 9 dargestellt. Fig. 9 zeigt die zu erreichende Temperatur für einzelne Heizelemente während unterschiedlicher Phasen der thermischen Behandlung sowie eine entsprechende Lüftereinstellung während der unterschiedlichen Phasen.

Dabei ist das Heizprofil der einzelnen Heizelemente 9 darauf ausgelegt, dass eine möglichst gleichmäßige Temperaturverteilung auf einer von der Heizplatte 4 wegweisenden Oberseite des Substrats 2 erreicht wird. Die Ansteuerung der einzelnen Heizelemente 9 erfolgt anhand eines PID-Regelalgorithmus, in den die Messergebnisse der den jeweiligen Heizelementen 9 zugeordneten Temperatursensoren als Ist-Werte eingehen, während die in Fig. 9 vorgegebenen Temperaturen für die unterschiedlichen Phasen der thermischen Behandlung Sollwerte darstellen.

In entsprechender Weise wird der Lüfter 34 gemäß dem vorgegebenen Lüfterprofil angesteuert, um über den Strömungskanal B und den Spalt A Umgebungsluft anzusaugen, die entlang der Außenkanten der Heizplatte 4 und der außen liegenden Heizelemente 9 strömt. Der Lüfter wird ebenfalls gemäß dem zuvor ermittelten Programm in vorgegebener Weise angesteuert, um eine entsprechende Randkühlung der Heizplatte 4 und der außen liegenden Heizelemente 9 zu erreichen.

Obwohl das einmal ermittelte Prozessprogramm für aufeinanderfolgende Prozesse unverändert eingesetzt werden könnte, ist bei dem dargestellten Ausführungsbeispiel eine Überwachung der Prozessergebnisse und gegebenenfalls eine Anpassung des Prozessprogramms vorgesehen.

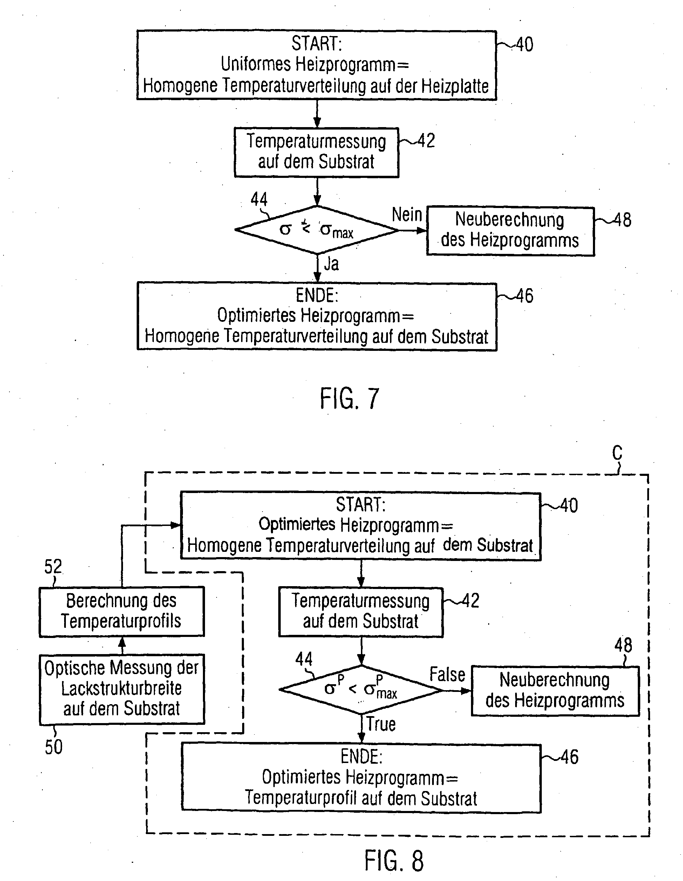

Beispielhaft für eine solche Überwachung und Anpassung zeigt Figur 7 eine schematische Darstellung eines Flussdiagramms für eine automatisierte Optimierung eines Prozessprogramms. Gemäß Fig. 7 wird im Block 40 eine thermische Behandlung eines Substrats unter Verwendung des vorgegebenen Prozessprogramms gestartet. Anschließend wird im Block 42 während der thermischen Behandlung die Temperatur auf der von der Heizplatte wegweisenden Oberfläche des Substrats ortsaufgelöst, d.h. an unterschiedlichen Ortspunkten gemessen. Aus den Messergebnissen, die von unterschiedlichen Ortspunkten auf der Oberseite des Substrats stammen, wird eine Homogenität der Temperaturverteilung berechnet, die durch δ dargestellt ist. Die Homogenität δ ergibt sich aus dem Koeffizienten:

$$\sum_{\Delta t} \frac{\Delta T(t)}{T(t)} \bigg/ \Delta t$$

In einem Entscheidungsblock 44 wird die berechnete Homogenität mit einem maximalen Homogenitätswert verglichen, der eine maximal erlaubte Temperaturabweichung darstellt. Wenn die Homogenität δ kleiner ist als der maximal erlaubte Homogenitätswert $\delta_{max}$, dann wird das Prozessprogramm in unveränderter Weise fortgesetzt, bis das Ende erreicht ist. Am Ende des Prozessprogramms wird im Schritt 46 die Ansteuerung der einzelnen Heizelemente 9 und des Lüfters 34 beendet und anschließend wir das Substrat 2 in bekannter Art und Weise entladen.

Wenn im Block 44 jedoch festgestellt wird, dass die Homogenität δ den maximal erlaubten Homogenitätswert $\delta_{max}$ übersteigt, dann wird im Schritt 48 das Prozessprogramm neu berechnet und das Heizprofil und/oder das Lüfterprofil verändert, um eine gleichmäßigere Temperaturverteilung auf dem Substrat zu erreichen. Bei der Neuberechnung des Prozessprogramms können insbesondere die zuvor festgelegten Sollwertprofile für die einzelnen Heizelemente gegenüber der ursprünglichen Vorgabe verändert werden. Eine derartige Prozesssteuerung ist beispielsweise für die Ansteuerung der Heizelemente in der DE 199 07 497 C2 beschrieben, auf die Bezug genommen wird, um Wiederholungen zu vermeiden. Diese Art der Prozesssteuerung dient dazu eine verbesserte Temperaturhomogenität auf der Oberfläche des Substrats 2 zu erreichen.

Alternativ oder zusätzlich hierzu kann auch die Ansteuerung des Lüfters 34 gegenüber dem vorgegebenen Lüfterprofil verändert werden, um beispielsweise eine rasche Randkühlung der Heizplatte 4 oder der außenliegenden Heizelemente 9 bzw. eine weniger starke Abkühlung derselben vorzusehen. Auch ist es möglich, die Breite des Spaltes A entlang der Umfangskante der Heizplatte 4 bzw. der außenliegenden Heizelemente 9 zu verändern. Diese Veränderung der Spaltbreite kann dabei entlang nur einer oder auch entlang mehrerer Kanten und auch nur in Teilbereichen vorgesehen werden, um hierdurch gezielt die durch die Luftströmung vorgesehene Kühlleistung, in dem Bereich, wo eine Verstellung vorgesehen wird, zu verändern.

Es bieten sich daher unterschiedlichste Möglichkeiten, um eine Homogenisierung der Temperatur auf der Oberfläche des Substrats 2 zu erreichen.

Das neu berechnete und veränderte Prozessprogramm wird nach Beendigung der thermischen Behandlung im Block 46 abgespeichert und als neues Prozessprogramm für eine nachfolgende thermische Behandlung bereitgestellt. Hierdurch lässt sich bei der thermischen Behandlung einer Vielzahl von Substraten 2 eine Selbstoptimierung des Systems erreichen.

Figur 8 zeigt ein alternatives Flussdiagramm für eine automatische Optimierung des Heizprogramms, wobei der Abschnitt C gemäß Fig. 8 im Wesentlichen dem zuvor beschriebenen Flussdiagramm entspricht. Daher werden im Abschnitt C dieselben Bezugszeichen wie in Fig. 7 verwendet. Dem Abschnitt C ist jedoch eine optische Messung der Lackstrukturbreite auf einem zuvor behandelten Substrat vorgeschaltet. Dabei ist diese optische Messung wiederum ortsauflösend, um lokale Unterschiede hinsichtlich der Lackstrukturbreite auf dem Substrat festzustellen, die wiederum einen Rückschluss auf das örtliche Temperaturprofil auf der Oberfläche des Substrats während der thermischen Behandlung zulässt, wie es beispielsweise in der US 6 235 439 B beschrieben ist. Die optische Messung der Lackstrukturbreite erfolgt in einem Block 50. Im nachfolgenden Schritt 52 wird das Temperaturprofil während der vorhergehenden thermischen Behandlung ortsaufgelöst berechnet und anhand des Temperaturprofils wird ein optimiertes Prozessprogramm ermittelt, das darauf abzielt, eine homogenere Temperaturverteilung auf dem Substrat zu erreichen. Dieses so optimierte Prozessprogramm wird dann im Block 40 als das Startprogramm verwendet, das während der thermischen Behandlung gegebenenfalls wie oben beschrieben nochmals verändert und anschließend gespeichert wird.

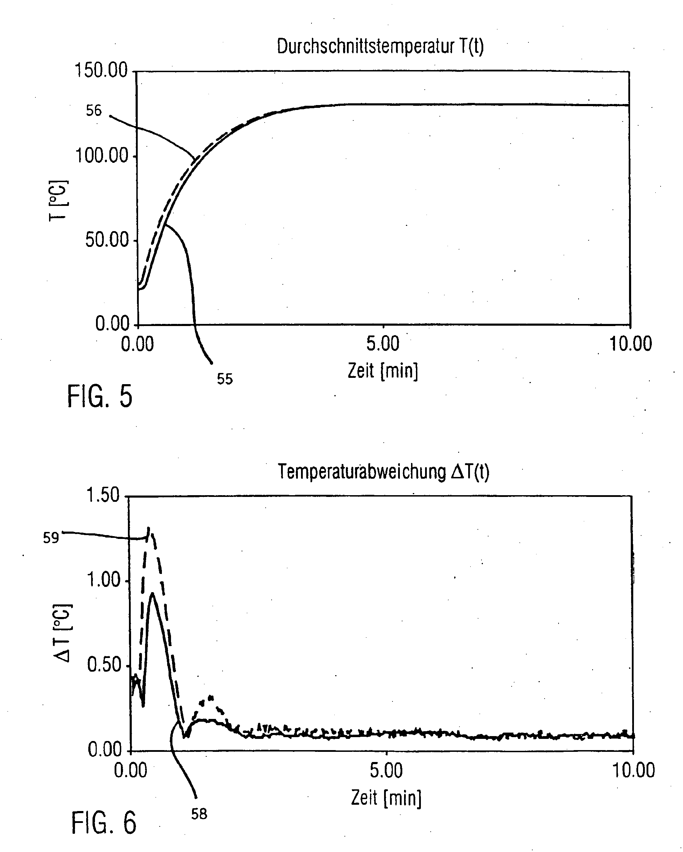

Die Figuren 5 und 6 zeigen einen Vergleich einer Durchschnittstemperatur T(t) bzw. einer Temperaturabweichung ΔT(t) auf einer Substratoberfläche zwischen einer thermischen Behandlung mit gesteuerter Luftabsaugung gemäß dem oben beschriebenen Ausführungsbeispiel und einer thermischen Behandlung ohne gesteuerte Luftabsaugung. Dabei zeigt in Figur 5 die Kurve 55 die durchschnittliche Temperatur T(t) auf der Substratoberfläche in Abhängigkeit von der Zeit während einer thermischen Behandlung gemäß der vorliegenden Erfindung, d.h. mit gesteuerter Luftabsaugung und die Kurve 56 die durchschnittliche Temperatur T(t) auf der Oberfläche des Substrats bei einem Prozessablauf ohne gesteuerte Luftabsaugung. Die Kurven 55 und 56 unterscheiden sich kaum und daher ist zu sehen, dass die gesteuerte Luftabsaugung nur einen geringen Einfluss auf die Durchschnittstemperatur T(t) auf einer Substratoberfläche besitzt.

In Figur 6 zeigt die Kurve 58 einer Temperaturabweichung ΔT(t) zwischen unterschiedlichen Ortspunkten auf einer Oberfläche eines Substrats bei einer thermischen Behandlung gemäß der vorliegenden Erfindung, d.h. mit gesteuerter Luftabsaugung. Die Kurve 59 zeigt hingegen eine Temperaturabweichung ΔT(t) zwischen entsprechenden Ortspunkten auf einem Substrat bei einer thermischen Behandlung ohne gesteuerte Luftabsaugung. Figur 6 zeigt deutlich, dass die Temperaturhomogenität insbesondere zu Beginn der thermischen Behandlung bei einem Prozess gemäß der vorliegenden Erfindung deutlich besser ist als bei dem Vergleichsprozess. Dies ist unter anderem darauf zurückzuführen, dass über die gesteuerte Luftabsaugung einer rascher Einfluss auf die Temperatur im Randbereich der Heizplatte bzw. der außen liegenden Heizelemente möglich ist, so dass Randeffekte rasch ausgeglichen werden können. Wie in Figur 6 ferner zu sehen ist, ist die Temperaturabweichung in einem Bereich, in dem eine im wesentlichen konstante Temperatur vorgesehen werden soll, bei beiden Prozessen im wesentlichen gleich, so dass die vorliegende Erfindung insbesondere eine Verbesserung der Homogenität , beispielsweise in einer Aufheizphase, d.h. während einer Temperaturveränderung gegeben ist. In gleicher Weise ist eine Verbesserung der Homogenität während einer Abkühlphase zu erwarten.

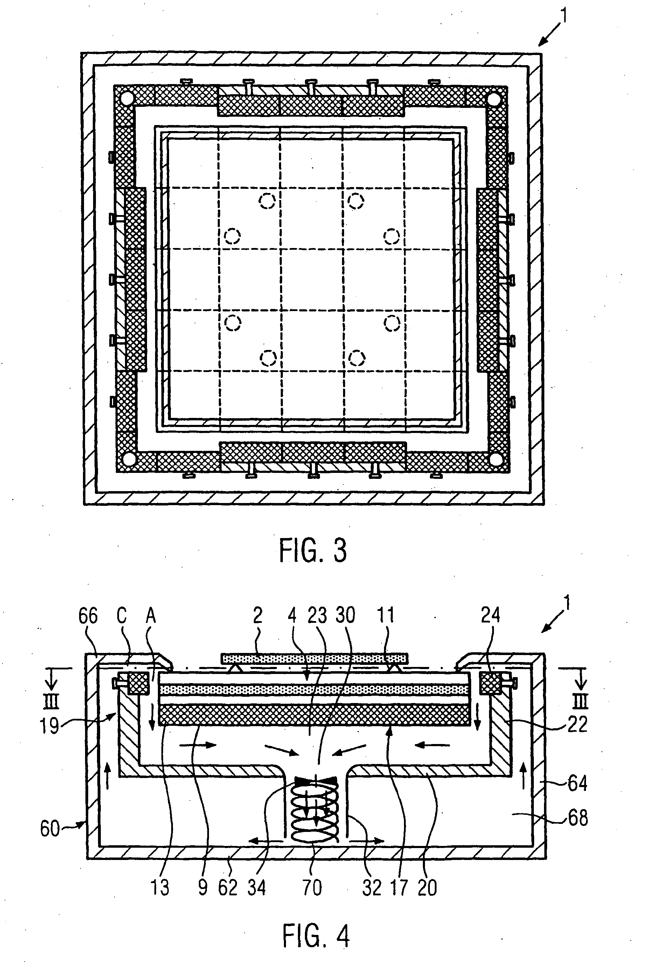

Die Figuren 3 und 4 zeigen eine alternative Heizvorrichtung 1 gemäß der vorliegenden Erfindung. In den Figuren 3 und 4 werden dieselben Bezugszeichen verwendet, sofern dieselben oder ähnliche Elemente bezeichnet werden. Fig. 3 zeigt eine Schnittansicht einer Heizvorrichtung 1 entlang der Linie III-III in Fig. 4 und Fig. 4 zeigt eine Querschnittsansicht der Heizvorrichtung 1.

Zur Vereinfachung der Darstellung ist ein Deckel, wie der Deckel 36 gemäß Figur 2 in den Figuren 3 und 4 nicht dargestellt.

Die Heizvorrichtung 1 besitzt im wesentlichen denselben Aufbau wie die Heizvorrichtung gemäß den Figuren 1 und 2 hinsichtlich einer Heizplatteneinheit 17 mit einer Heizplatte 4, Heizelementen 9 und einer Isolierplatte 13. Wiederum sind Aufnahmeelemente 11 zum beabstandeten Halten eines Substrats 2 oberhalb der Heizplatte 4 vorgesehen.

Auch ist ein Rahmenelement 19 mit einer Bodenwand 20 und Seitenwänden 22 sowie verstellbar daran angeordneten Elementen 24 vorgesehen. Das Rahmenelement 19 ist jedoch von einem weiteren Rahmenelement 60 mit einer Bodenwand 62, Seitenwänden 64 sowie einer oberen Wand 66 umgeben. Die obere Wand 66 steht mit der Oberseite der Heizplatte 4 an dessen Randbereich in Kontakt, wie in den Figuren 3 und 4 dargestellt ist, und besitzt im Wesentlichen dieselbe Funktion wie das Umlenkelement 26 gemäß dem ersten Ausführungsbeispiel. Zwischen dem Rahmenelement 19 und dem Rahmenelement 60 wird eine Strömungskammer 68 gebildet, die über einen Spalt C mit dem Spalt A zwischen dem Rahmenelement 19 und der Heizplatteneinheit 17 gebildet wird. Über die Mittelöffnung 30 in der Bodenwand 20 des Rahmenelements 19 steht der Strömungsraum 23, zwischen der Unterseite der Heizplatteneinheit 17 und der Bodenwand 20 des Rahmenelements 19 mit der Strömungskammer 68 in Verbindung.

Im Bereich der Mittelöffnung 30 ist wiederum ein Absaugrohr 32 vorgesehen, in dem ein Lüfter 34 angeordnet ist, um Luft aus dem Strömungsraum 23 herauszusaugen und in die Strömungskammer 68 zu leiten. Hierdurch wird ein geschlossener Strömungskreislauf zwischen den beiden Rahmenelementen und der Heizplatteneinheit 17 vorgesehen, der durch mehrere Strömungspfeile in Fig. 4 dargestellt ist. Im Bereich des Absaugrohrs 32 ist eine Kühl-/Heizvorrichtung 70 angeordnet, um die durch den Kreislauf zirkulierte Luft auf eine gewünschte Temperatur zu bringen. Dabei wird die Luft vorzugsweise während der Zirkulation auf eine vorbestimmte Temperatur gekühlt, um im Bereich des Spalts A eine bestimmte Abkühlung im Randbereich der Heizplatte 4 bzw. eine Abkühlung im Randbereich der außenliegenden Heizelemente 9 vorzusehen.

Der Betrieb der vorliegenden Erfindung entspricht im Wesentlichen dem zuvor beschriebenen Betrieb, wobei als zusätzlicher Steuerparameter die Temperatur der durch den Spalt A geleiteten Luft gesteuert werden kann.

Wie dem Fachmann ohne weiteres ersichtlich ist, könnte die in Figur 4 dargestellte Strömungsrichtung ohne weiteres auch umgekehrt werden, d.h. dass der Lüfter 34 Luft aus der Strömungskammer 68 absaugt und in die Strömungskammer 23 leitet. Auch könnte in dem Strömungskreislauf statt Luft ein anderes Kühlgas eingesetzt werden.

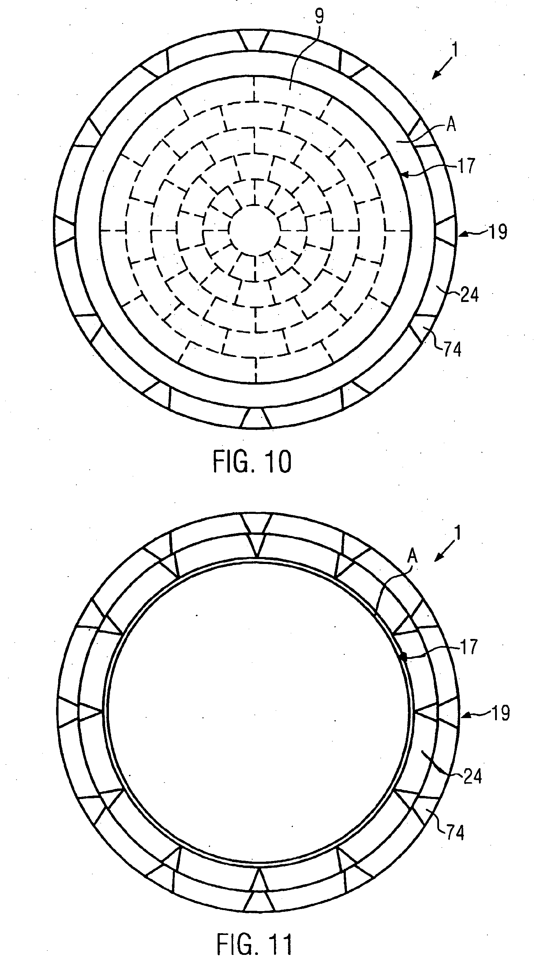

Die Figuren 10 bis 12 zeigen verschiedene Draufsichten auf eine Heizvorrichtung 1 gemäß einem weiteren Ausführungsbeispiel der vorliegenden Erfindung, wobei einstellbare Elemente der Vorrichtung 1 in unterschiedlichen Positionen dargestellt sind. Bei der Beschreibung des Ausführungsbeispiels gemäß den Figuren 10 bis 12 werden dieselben Bezugszeichen verwendet, sofern identische oder äquivalente Elemente bezeichnen werden.

Die Heizvorrichtung 1 weist eine Heizplatteneinheit 17 auf, die bei dem dargestellten Ausführungsbeispiel in der Draufsicht rund ist und, für die thermische Behandlung von runden Substraten vorgesehen ist. Die Heizplatteneinheit 17 besitzt im wesentlichen denselben Aufbau wie die Heizplatteneinheit 17 gemäß den vorhergehenden Ausführungsbeispielen, bestehend aus einer oberen Heizplatte sowie darunter liegenden einzelnen Heizelementen 9, die schematisch in Figur 10 durch eine strichpunktierte Linie dargestellt sind. Die einzelnen Heizelemente 9 können unterschiedliche Formen annehmen und auch die Anzahl der Heizelemente kann beliebig gewählt werden, jedoch sollte die Anordnung der Heizelemente 9 möglichst eine Kreissymmetrie besitzen. Gemäß dem dargestellten Ausführungsbeispiel ist eine Vielzahl von ringsegmentförmigen Heizelementen 9 in kleiner werdenden konzentrischen Ringbereichen vorgesehen.

Die Vorrichtung 1 weist ferner ein Rahmenelement 19 auf, das die Heizplatteneinheit 17 in Radialrichtung und auf ihrer Rückseite umgibt. In einer nicht näher dargestellten Bodenwand der Rahmeneinheit 19 ist wiederum eine mittige Öffnung vorgesehen, die mit einem Absaugrohr und einem darin angeordneten Lüfter in Verbindung steht.

An dem Rahmenelement 19 ist wiederum eine Vielzahl von verstellbaren Elementen 24 vorgesehen, die als Ringsegmente ausgebildet sind. Zwischen den jeweiligen verstellbaren Elementen 24 ist ein feststehender Teil 74 des Rahmenelements 19 vorgesehen, das eine Höhe besitzt, die der Höhe der verstellbaren Elemente 24 entspricht.

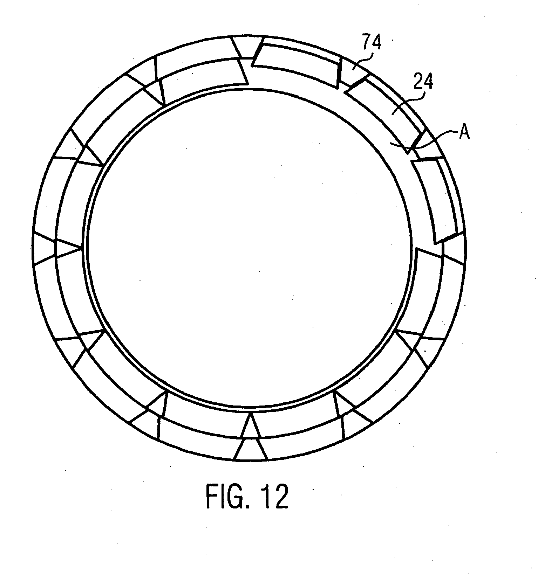

Die verstellbaren Elemente sind zwischen einer maximalen nach außen bewegten Position gemäß Figur 10 und einer maximalen nach innen bewegten Position gemäß Figur 11 verstellbar, um einen zwischen dem Rahmenelement 19 und der Heizplatteneinheit 17 gebildeten Spalt A zu verändern. Dabei ist eine individuelle Verstellung der Elemente 24 genauso möglich, wie eine gruppenweise Einstellung. Eine beispielhafte Einstellung der verstellbaren Elemente 24, bei der in Umfangsrichtung unterschiedliche Spaltgrößen A vorgesehen werden, um beispielsweise lokale Temperaturinhomogenitäten auszugleichen, ist in Fig. 12 dargestellt.

Der Betrieb der Heizvorrichtung 1 gemäß der vorliegenden Erfindung entspricht im Wesentlichen dem Betrieb der Vorrichtung gemäß den vorhergehenden Ausführungsbeispielen.

Die Erfindung wurde zuvor anhand eines bevorzugten Ausführungsbeispiels der Erfindung näher erläutert, ohne jedoch auf das konkret dargestellte Ausführungsbeispiel beschränkt zu sein. So sind beispielsweise die Merkmale der unterschiedlichen Ausführungsbeispiele frei miteinander kombinierbar und austauschbar, sofern sie kompatibel sind. Ferner sind natürlich auch unterschiedliche Formen der Heizplatteneinheit sowie der Rahmeneinheit denkbar. Eine Temperatursteuerung des durch den Spalt A geleiteten Gases ist beispielsweise auch bei dem Ausführungsbeispiel gemäß den Figuren 1 und 2 möglich, wenn beispielsweise der Strömungsspalt B mit einer Gasquelle in Verbindung steht die eine Temperatursteuerung des Gases ermöglicht, wie beispielsweise eine Klimaanlage.

## Patentansprüche

1. Verfahren zum thermischen Behandeln von Substraten (2), bei dem die Substrate in Kontakt mit oder eng beabstandet zu einer Heizplatte (4) gehalten werden, die über eine Vielzahl von separat ansteuerbaren Heizelementen (9) auf der vom Substrat abgewandten Seite der Heizplatte erwärmt wird, **dadurch gekennzeichnet, dass** die Heizplatte (4) in ihrer Ebene von einem hierzu beabstandeten Rahmen (19) umgeben ist und Gas durch einen Spalt (A) zwischen dem Rahmen und wenigstens einer Kante der Heizplatte geleitet wird, wobei das Gas derart geleitet wird, dass es nicht in Kontakt mit dem Substrat gelangt, und wobei die Durcliflussmenge und/oder die Temperatur des Gases gesteuert wird, um die Temperatur der Kante der Heizplatte zu beeinflussen.

2. Verfahren nach Anspruch 1, **dadurch gekennzeichnet, dass** die Breite des Spalts entlang wenigstens eines Teilbereichs einer Kante der Heizplatte vor und/oder während einer thermischen Behandlung eines Substrats verändert wird.

3. Verfahren nach Anspruch 1 oder 2, **dadurch gekennzeichnet, dass** die Breite des Spalts lokal in einem Bereich zwischen 0 und 5 mm verändert wird.

4. Verfahren nach Anspruch 3, **dadurch gekennzeichnet, dass** die Breite des Spalts lokal in einem Bereich zwischen 1 und 5 mm, verändert wird.

5. Verfahren nach einem der vorhergehenden Ansprüche, **dadurch gekennzeichnet, dass** das Gas vor dem Eintritt in den Spalt an einem Umlenkelement umgelenkt wird.

6. Verfahren nach einem der vorhergehenden Ansprüche, **dadurch gekennzeichnet, dass** das Gas Umgebungsluft ist.

7. Verfahren nach einem der vorhergehenden Ansprüche, **dadurch gekennzeichnet, dass** das Gas ein Kühlgas ist, dass in einem geschlossenen Kühlkreis zirkuliert.

8. Verfahren nach einem der vorhergehenden Ansprüche, **dadurch gekennzeichnet, dass** die Temperatur des Gases vor dem Eintritt in den Spalt gesteuert wird.

9. Verfahren nach einem der vorhergehenden Ansprüche, **dadurch gekennzeichnet, dass** die durch den Spalt geleitete Gasmenge, die Spaltbreite und/oder die Temperatur des Gases anhand eines vor der thermischen Behandlung ermittelten Profils gesteuert wird.

10. Verfahren nach Anspruch 9, **dadurch gekennzeichnet, dass** die Temperatur auf der von der Heizplatte abgewandten Seite des Substrats ortsauflösend gemessen wird und das vor der thermischen Behandlung ermittelte Profil für die durch den Spalt geleitete Gasmenge, die Spaltbreite und/oder die Temperatur des Gases in Abhängigkeit von der gemessenen Temperatur auf dem Substrat verändert wird, wenn Temperaturunterschiede zwischen unterschiedlichen Ortspunkten auf der Oberfläche des Substrats einen Schwellenwert übersteigen.

11. Verfahren nach Anspruch 10, **dadurch gekennzeichnet, dass** ein während einer thermischen Behandlung verändertes Profil für die durch den Spalt geleitete Gasmenge, die Spaltbreite und/oder die Temperatur des Gases gespeichert und für eine nachfolgende Behandlung als neu ermitteltes Profil verwendet wird.

12. Verfahren nach einem der vorhergehenden Ansprüche, **gekennzeichnet durch** ortsaufgelöstes Messen der Temperatur auf der von der Heizplatte abgewandten Seite des Substrats, Messen der Temperatur jedes Heizelements, und Regeln der Temperatur jedes Heizelements mit einem PID-Regelalgorithmus, in den die gemessene Temperatur des Heizelements als Ist-Wert eingeht und wobei ein vor der thermischen Behandlung ermitteltes Sollwertprofil der Temperatur für den PID-Regelalgorithmus in Abhängigkeit von der gemessenen Temperatur auf dem Substrat verändert wird, wenn Temperaturunterschiede zwischen unterschiedlichen Ortspunkten auf der Oberfläche des Substrats einen Schwellenwert übersteigen.

13. Verfahren nach Anspruch 12, **dadurch gekennzeichnet, dass** ein während einer thermischen Behandlung verändertes Sollwertprofil gespeichert und für eine nachfolgende Behandlung als neu ermitteltes Sollwertprofil verwendet wird.

14. Verfahren nach einem der vorhergehenden Ansprüche, **dadurch gekennzeichnet, dass** eine Strukturbreite, insbesondere eine Lackstrukturbreite, nach einer thermischen Behandlung des Substrats ortsauflösend auf der Oberfläche des Substrats gemessen wird, dass anhand der Messung ein ortsaufgelöstes Temperaturprofil der Oberfläche des Substrats berechnet wird, und dass die durch den Spalt geleitete Gasmenge, die Spaltbreite, die Temperatur des Gases und/oder ein Ansteuerprofil für die Heizelemente in Abhängigkeit vom berechneten Temperaturprofil auf dem Substrat für eine nachfolgende thermische Behandlung eines Substrats eingestellt wird.

15. Vorrichtung (1) zum thermischen Behandeln von Substraten (2), mit einer Heizplatte (4), Mitteln (11) zum Halten eines Substrats (2) in Kontakt mit oder eng beabstandet zu der Heizplatte (4) und einer Vielzahl von separat ansteuerbaren Heizelementen (9) auf der vom Substrat abgewandten Seite der Heizplatte (4), **gekennzeichnet durch** einen Rahmen (19), der die Heizplatte (4) in ihrer Ebene umgibt, wobei der Rahmen (19) zur Heizplatte (4) beabstandet ist und wenigstens ein Spalt (A) zwischen dem Rahmen (19) und wenigstens einer Kante der Heizplatte (4) gebildet ist, wenigstens eine Einrichtung (34) zum Leiten von Gas **durch** den Spalt (A), wobei die Einrichtung (34) die Durchflussmenge und/oder die Temperatur des **durch** den Spalt (A) geleiteten Gases steuert, und Mittel zum Leiten des Gases derart, dass es nicht in Kontakt mit dem Substrat gelangt.

16. Vorrichtung(1) nach Anspruch 15, **gekennzeichnet durch** wenigstens ein verstellbar am Rahmen (19) angebrachtes Element (24) zum lokalen Einstellen der Breite des Spalts (A).

17. Vorrichtung (1) nach Anspruch 15 oder 16, **dadurch gekennzeichnet, dass** die Breite des Spalts (A) lokal zwischen 0 und 5 mm verstellbar ist.

18. Vorrichtung (1) nach Anspruch 15 oder 16, **dadurch gekennzeichnet, dass** die Breite des Spalts (A) lokal zwischen 1 und 5 mm verstellbar ist.

19. Vorrichtung (1) nach einem der Ansprüche 16 bis 18, **gekennzeichnet durch** eine Vielzahl von Elementen (24) entlang einer Kante der Heizplatte (4).

20. Vorrichtung (1) nach Anspruch 17 oder 18, **dadurch gekennzeichnet, dass** eine zur Heizplatte (4) weisende Kontur des Elements (24) komplementär zu einer Kontur einer ihm gegenüberliegenden Kante der Heizplatte (4) ist.

21. Vorrichtung (1) nach einem der Ansprüche 15 bis 20, **dadurch gekennzeichnet, dass** der Rahmen (19) eine Bodenwand (20) und wenigstens eine Seitenwand (22) aufweist, wobei die wenigstens eine Seitenwand (22) die Heizplatte (4) in ihrer Ebene umgibt, wobei oberhalb der Bodenwand ein Strömungsraum (23) gebildet wird, der mit dem Spalt (A) in Verbindung steht, und wobei die Einrichtung (34) zum Leiten von Gas durch den Spalt (A) mit einer Öffnung (30) in der Bodenwand (22) des Rahmens (19) in Verbindung steht.

22. Vorrichtung (1) nach einem der Ansprüche 15 bis 21, **gekennzeichnet durch** ein Umlenkelement, das die Heizplatte (4) in ihrem Randbereich auf ihrer Oberseite kontaktiert und an einem Ende des Spalts (A) einen Strömungskanal bildet.

23. Vorrichtung (1) nach einem der Ansprüche 15 bis 22, **dadurch gekennzeichnet, dass** der Spalt (A) mit Umgebungsluft in Verbindung steht.

24. Vorrichtung (1) nach einem der Ansprüche 15 bis 22, **dadurch gekennzeichnet, dass** der Spalt (A) Teil eines geschlossenen Strömungskreislaufs ist, in dem eine Kühl- und/oder Heizvorrichtung (70) angeordnet ist.

25. Vorrichtung (1) nach einem der Ansprüche 15 bis 24, **gekennzeichnet durch** eine auf die von der Heizplatte (4) abgewandte Oberfläche des Substrats (2) gerichtete, ortsauflösende Temperatur-Meßvorrichtung und eine Prozesssteuereinheit, die mit der Temperatur-Meßvorrichtung und der Einrichtung (34) zum Leiten von Gas **durch** den Spalt (A) in Verbindung steht, um die Temperaturverteilung auf der Substratoberfläche anhand von Messdaten der ortsauflösenden Temperatur-Meßvorrichtung zu ermitteln und die Einrichtung zum Leiten von Gas **durch** den Spalt (A) anhand der Temperaturverteilung anzusteuern, um die Durchflussmenge und/oder die Temperatur des **durch** den Spalt (A) geleiteten Gases zu steuern.

26. Vorrichtung (1) nach einem der Ansprüche 15 bis 25, **dadurch gekennzeichnet, dass** jedem Heizelement (9) ein Temperatursensor zugeordnet ist, um dessen Temperatur zu messen und dass wenigstens ein PID-Regler vorgesehen ist, der mit den Heizelementen (9) und dem zugeordneten Temperatursensoren verbunden ist.

27. Vorrichtung (1) nach Anspruch 26, **dadurch gekennzeichnet, dass** für jedes Heizelement (9) ein PID-Regler vorgesehen ist.

28. Vorrichtung (1) nach Anspruch 26 oder 27, **dadurch gekennzeichnet, dass** die Prozesssteuereinheit mit dem/den PID-Regler(n) in Verbindung steht und in Abhängigkeit von einer Temperaturverteilung auf der von der Heizplatte (4) wegweisenden Substratoberfläche Temperatur-Sollwerte für die einzelnen Heizelemente (9) ermittelt und an den/die PID-Regler übermittelt.

29. Vorrichtung nach einem der Ansprüche 15 bis 28, **dadurch gekennzeichnet, dass** die Einrichtung (34) zum Leiten von Gas durch den Spalt (A) zentriert unterhalb der der Heizplatte angeordnet ist.

30. Vorrichtung nach einem der Ansprüche 15 bis 29, **dadurch gekennzeichnet, dass** die Einrichtung (34) zum Leiten von Gas durch den Spalt (A) eine Absaugeinrichtung ist.

31. Vorrichtung nach einem der Ansprüche 15 bis 29, **dadurch gekennzeichnet, dass** die Einrichtung (34) zum Leiten von Gas durch den Spalt (A) eine Steuereinheit aufweist um die durch den Spalt geleiteten Gasmenge, und/oder die Temperatur des Gases einzustellen.

32. Vorrichtung nach einem der Ansprüche 15 bis 30, **gekennzeichnet durch** eine Einrichtung zum ortsauflösenden Messen einer Strukturbreite, insbesondere einer Lackstrukturbreite, auf der Oberfläche eines Substrats.

**Claims**

1. A method for the thermal treatment of substrates (2), in which the substrates are held in contact with or a small distance away from a heating plate (4), which is heated by a plurality of separately controllable heating elements (9), arranged on the side of the heating plate facing away from the substrate, **characterised in that** the heating plate (4) is surrounded in its plane by a frame (19), which is spaced apart from said heating plate, and that gas is conveyed through a gap between the frame and at least one edge of the heating plate, wherein the gas is conveyed such that it does not come into contact with the substrate, and wherein the quantity and/or the temperature of the gas flowing through said gap is controlled in order to influence the temperature of the edge of the heating plate.

2. The method according to Claim 1, **characterised in that** the width of the gap along at least a partial region of an edge of the heating plate is changed before and/or during a thermal treatment of a substrate.

3. The method according to Claim 1 or 2, **characterised in that** the width of the gap is changed locally in a range of between 0 and 5 mm.

4. The method according to Claim 3, **characterised in that** the width of the gap is changed locally in a range of between 1 and 5 mm.

5. The method according to one of the preceding claims, **characterised in that** the flow of gas is deflected by a deflection element before entering the gap.

6. The method according to one of the preceding claims, **characterised in that** the gas is ambient air.

7. The method according to one of the preceding claims, **characterised in that** the gas is a cooling gas which circulates in a closed cooling circuit.

8. The method according to one of the preceding claims, **characterised in that** the temperature of the gas is controlled before entering into the gap.

9. The method according to one of the preceding claims, **characterised in that** the quantity of gas conveyed through the gap, the gap width and/or the temperature of the gas are controlled by means of a profile established before the thermal treatment.

10. The method according to Claim 9, **characterised in that** the temperature is measured location-specific on the side of the substrate facing away from the heating plate, and that the profile which was established before the thermal treatment for the quantity of gas conveyed through the gap, the gap width and/or the temperature of the gas is changed in accordance with the temperature measured on the substrate, if the temperature differences between different location points on the surface of the substrate exceed a threshold value.

11. The method according to Claim 10, **characterised in that** a profile which was changed during a thermal treatment for the quantity of gas conveyed through the gap, the gap width and/or the temperature of the gas is stored and used as a newly established profile for a subsequent treatment.

12. The method according to one of the preceding claims, **characterised by** location-specific measurement of the temperature on the side of the substrate facing away from the heating plate, measurement of the temperature of each heating element, and closed-loop control of the temperature of each heating element using a PID regulation algorithm, in which the measured temperature of the heating element is entered as an actual value, and wherein a desired profile of the temperature for the PID regulation algorithm, which was determined before the thermal treatment, is changed in accordance with the temperature measured on the substrate, if the temperature differences between different location points on the surface of the substrate exceed a threshold value.

13. The method according to Claim 12, **characterised in that** a desired profile, which was changed during a thermal treatment is stored and used for a subsequent treatment as a newly established desired profile.

14. The method according to one of the preceding claims, **characterised in that** a structure width, in particular a lacquer structure width, is measured location-specific on the surface of the substrate after a thermal treatment of the substrate, by means of the measurement, a location-specific temperature profile is calculated for the surface of the substrate, and the quantity of gas conveyed through the gap, the gap width, the temperature of the gas and/or a control profile for the heating elements are set for a subsequent thermal treatment of a substrate in accordance with the temperature profile calculated on the substrate.

15. A device (1) for the thermal treatment of substrates (2), said device having a heating plate (4), means (11) for holding a substrate (2) in contact with or a small distance away from the heating plate (4), and a plurality of separately controllable heating elements (9) on the side of the heating plate (4) facing away from the substrate, said device being **characterised by** a frame (19) which surrounds the heating plate (4) in its plane, wherein the frame (19) is spaced apart from the heating plate (4), and at least one gap (A) is formed between the frame (19) and at least one edge of the heating plate (4),

at least one device (34) for conveying gas through the gap (A), wherein the device (34) controls the quantity and/or the temperature of the gas conveyed through the gap (A), and

means for conveying the gas such that it does not come into contact with the substrate.

16. The device (1) according to Claim 15, **characterised by** at least one element (24) adjustably mounted to the frame (19) for local adjustment of the width of the gap (A).

17. The device (1) according to Claim 15 or 16, **characterised in that** the width of the gap (A) is adjustable locally between 0 and 5 mm.

18. The device (1) according to Claim 15 or 16, **characterised in that** the width of the gap (A) is adjustable locally between 1 and 5 mm.

19. The device (1) according to one of Claims 16 to 18, **characterised by** a plurality of said elements (24) along one edge of the heating plate (4).

20. The device (1) according to Claim 17 or 18, **characterised in that** a contour of the element (24) facing towards the heating plate (4) is complementary to a contour of an opposite edge of the heating plate (4).

21. The device (1) according to one of Claims 15 to 20, **characterised in that** the frame (19) has a bottom wall (20) and at least one side wall (22), wherein the at least one side wall (22) surrounds the heating plate (4) in its plane, wherein a flow space (23) is formed above said bottom wall (20), said flow space (23) being connected to the gap (A), and wherein the device (34) for conveying gas through the gap (A) is connected to an opening (30) in the bottom wall (22) of the frame (19).

22. The device (1) according to one of Claims 15 to 21, **characterised by** a deflection element which contacts the heating plate (4) in its edge region on its upper side, and forms a flow channel at one end of the gap (A).

23. The device (1) according to one of Claims 15 to 22, **characterised in that** the gap (A) is connected to ambient air.

24. The device (1) according to one of Claims 15 to 22, **characterised in that** the gap (A) forms part of a closed flow circuit in which a cooling and/or heating device (70) is/are disposed.

25. The device (1) according to one of Claims 15 to 24, **characterised by** a location-specific temperature measurement device directed onto the surface of the substrate (2) facing away from the heating plate (4), and

a process control unit which is connected to the temperature measurement device and the device (34) for conveying gas through the gap (A) in order to determine the temperature distribution on the substrate surface using measurement data from the location-specific temperature measurement device, and to control the device for conveying gas through the gap (A) in accordance with the temperature distribution in order to control the quantity and/or the temperature of the gas conveyed through the gap (A).

26. The device (1) according to one of Claims 15 to 25, **characterised in that** a temperature sensor is allocated to each heating element (9) in order to measure its temperature, and that at least one PID regulator is provided, which is connected to the heating elements (9) and the allocated temperature sensors.

27. The device (1) according to Claim 26, **characterised in that** a PID regulator is provided for each heating element (9).

28. The device (1) according to Claim 26 or 27, **characterised in that** the process control unit is connected to the PID regulator(s), and establishes, in accordance with a temperature distribution on the substrate surface facing away from the heating plate (4), desired temperature values for the individual heating elements (9) and communicates these to the PID regulator(s).

29. The device according to one of Claims 15 to 28, **characterised in that** the device (34) for conveying gas through the gap (A) is disposed centrally below the heating plate.

30. The device according to one of Claims 15 to 29, **characterised in that** the device (34) for conveying gas through the gap (A) is a suction device.

31. The device according to one of Claims 15 to 29, **characterised in that** the device (34) for conveying gas through the gap (A) has a control unit in order to adjust the quantity and/or the temperature of the gas conveyed through the gap.

32. The device according to one of Claims 15 to 30, **characterised by** a device for the location-specific measurement of a structure width, in particular of a lacquer structure width, on the surface of a substrate.

## Revendications

1. Procédé de traitement thermique de substrats (2), dans lequel les substrats sont maintenus en contact avec une plaque chauffante (4), ou à une distance limitée de celle-ci, qui est chauffée par une pluralité d'éléments chauffants (9) contrôlables séparément qui sont disposés sur le côté de la plaque chauffante opposé au substrat, **caractérisé en ce que** la plaque chauffante (4) est entourée dans son plan par un cadre (19), qui est espacé de la plaque chauffante, et du gaz est guidé dans un intervalle entre le cadre et au moins un bord de la plaque chauffante, le gaz étant guidé de telle sorte qu'il ne vienne pas en contact avec le substrat, et la quantité et/ou la température du gaz passant dans ledit intervalle est contrôlée afin d'influencer la température du bord de la plaque chauffante.

2. Procédé selon la revendication 1, **caractérisé en ce que** la largeur de l'intervalle le long d'au moins une région partielle d'un bord de la plaque chauffante est modifiée avant et/ou pendant un traitement thermique d'un substrat.

3. Procédé selon la revendication 1 ou 2, **caractérisé en ce que** la largeur de l'intervalle est modifiée localement dans une plage comprise entre 0 et 5 mm.

4. Procédé selon la revendication 3, **caractérisé en ce que** la largeur de l'intervalle est modifiée localement dans une plage comprise entre 1 et 5 mm.

5. Procédé selon l'une quelconque des revendications précédentes, **caractérisé en ce que** le flux de gaz est dévié par un élément de déflexion avant d'entrer dans l'intervalle.

6. Procédé selon l'une quelconque des revendications précédentes, **caractérisé en ce que** le gaz est de l'air ambiant.

7. Procédé selon l'une quelconque des revendications précédentes, **caractérisé en ce que** le gaz est un gaz de refroidissement qui circule dans un circuit de refroidissement fermé.

8. Procédé selon l'une quelconque des revendications précédentes, **caractérisé en ce que** la température du gaz est contrôlée avant qu'il pénètre dans l'intervalle.

9. Procédé selon l'une quelconque des revendications précédentes, **caractérisé en ce que** la quantité de gaz guidée dans l'intervalle, la largeur de l'intervalle et/ou la température du gaz sont contrôlées au moyen d'un profil établi avant le traitement thermique.

10. Procédé selon la revendication 9, **caractérisé en ce que** la température est mesurée spécifiquement en fonction de l'emplacement sur le côté du substrat opposé à la plaque chauffante, et **en ce que** le profil, qui a été établi avant le traitement thermique, pour la quantité de gaz guidée dans l'intervalle, la largeur de l'intervalle et/ou la température du gaz, est modifié conformément à la température mesurée sur le substrat, si les différences de température entre des points d'emplacements différents sur la surface du substrat dépassent une valeur de seuil.

11. Procédé selon la revendication 10, **caractérisé en ce qu'**un profil, qui a été modifié pendant un traitement thermique pour la quantité de gaz guidée dans l'intervalle, la largeur de l'intervalle et/ou la température du gaz, est mémorisé et utilisé en tant que nouveau profil établi pour un traitement ultérieur.

12. Procédé selon l'une quelconque des revendications précédentes, **caractérisé par** :

    une mesure spécifique en fonction de l'emplacement de la température sur le côté du substrat opposé à la plaque chauffante, une mesure de la température de chaque élément chauffant, et un asservissement de la température de chaque élément chauffant en utilisant un algorithme de régulation PID, dans lequel la température mesurée de l'élément chauffant est introduite comme valeur actuelle, et dans lequel un profil souhaité de la température pour l'algorithme de régulation PID, qui a été déterminé avant le traitement thermique, est modifié conformément à la température mesurée sur le substrat, si les différences de température entre des points d'emplacements différents sur la surface du substrat dépassent une valeur de seuil.

13. Procédé selon la revendication 12, **caractérisé en ce qu'**un profil souhaité, qui a été modifié pendant un traitement thermique, est mémorisé et utilisé pour un traitement ultérieur en tant que profil souhaité nouvellement établi.

14. Procédé selon l'une quelconque des revendications précédentes, **caractérisé en ce que** :

    une largeur de structure, en particulier une largeur de structure de laque, est mesurée de façon spécifique à l'emplacement sur la surface du substrat après un traitement thermique du substrat,

au moyen de la mesure, un profil de température spécifique à l'emplacement est calculé pour la surface du substrat, et

la quantité de gaz guidée dans l'intervalle, la largeur de l'intervalle, la température du gaz et/ou un profil de commande pour les éléments chauffants sont réglés pour un traitement thermique ultérieur d'un substrat conformément au profil de température calculé sur le substrat.

**15.** Dispositif (1) pour le traitement thermique de substrats (2), le dispositif comportant une plaque chauffante (4), des moyens (11) pour maintenir un substrat (2) en contact avec la plaque chauffante (4), ou à une distance limitée de celle-ci, et une pluralité d'éléments chauffants (9) contrôlables séparément sur le côté de la plaque chauffante (4) opposé au substrat, le dispositif étant **caractérisé par** :

un cadre (19) qui entoure la plaque chauffante (4) dans son plan, le cadre (19) étant espacé de la plaque chauffante (4), et au moins un intervalle (A) est formé entre le cadre (19) et au moins un bord de la plaque chauffante (4),

au moins un dispositif (34) pour guider le gaz dans l'intervalle (A), le dispositif (34) contrôlant la quantité et/ou la température du gaz guidé dans l'intervalle (A), et

des moyens pour guider le gaz de telle sorte qu'il ne vienne pas en contact avec le substrat.

**16.** Dispositif (1) selon la revendication 15, **caractérisé par** au moins un élément (24) monté de façon réglable sur le cadre (19) pour permettre un réglage local de la largeur de l'intervalle (A).

**17.** Dispositif (1) selon la revendication 15 ou 16, **caractérisé en ce que** la largeur de l'intervalle (A) est réglable localement entre 0 et 5 mm.

**18.** Dispositif (1) selon la revendication 15 ou 16, **caractérisé en ce que** la largeur de l'intervalle (A) est réglable localement entre 1 et 5 mm.

**19.** Dispositif (1) selon l'une quelconque des revendications 16 à 18, **caractérisé par** une pluralité desdits éléments (24) le long d'un bord de la plaque chauffante (4).

**20.** Dispositif (1) selon la revendication 17 ou 18, **caractérisé en ce qu'**un contour de l'élément (24) orienté vers la plaque chauffante (4) est complémentaire d'un contour d'un bord opposé de la plaque chauffante (4).

**21.** Dispositif (1) selon l'une quelconque des revendications 15 à 20, **caractérisé en ce que** le cadre (19) comporte une paroi inférieure (20) et au moins une paroi latérale (22), ladite au moins une paroi latérale (22) entourant la plaque chauffante (4) dans son plan, un espace de flux (23) étant formé au-dessus de la paroi inférieure (20), l'espace de flux (23) étant relié à l'intervalle (A), et le dispositif (34) destiné à guider le gaz dans l'intervalle (A) étant relié à une ouverture (30) dans la paroi inférieure (22) du cadre (19).

**22.** Dispositif (1) selon l'une quelconque des revendications 15 à 21, **caractérisé par** un élément de déflexion qui contacte la plaque chauffante (4) dans sa région de bord sur son côté supérieur, et forme un canal de flux au niveau d'une extrémité de l'intervalle (A).

**23.** Dispositif (1) selon l'une quelconque des revendications 15 à 22, **caractérisé en ce que** l'intervalle (A) est relié à de l'air ambiant.

**24.** Dispositif (1) selon l'une quelconque des revendications 15 à 22, **caractérisé en ce que** l'intervalle (A) fait partie d'un circuit fermé de flux dans lequel un dispositif de refroidissement et/ou de chauffage (70) est/sont disposés.

**25.** Dispositif (1) selon l'une quelconque des revendications 15 à 24, **caractérisé par** :

un dispositif de mesure de température spécifique à l'emplacement dirigé vers la surface du substrat (2) opposée à la plaque chauffante (4), et

un module de commande de processus qui est connecté au dispositif de mesure de température et au dispositif (34) pour guider le gaz dans l'intervalle (A) afin de déterminer la distribution de température sur la surface du substrat en utilisant des données de mesures provenant du dispositif de mesure de température spécifique à l'emplacement, et pour contrôler le dispositif destiné à guider le gaz dans l'intervalle (A) conformément à la distribution de température afin de contrôler la quantité et/ou la température du gaz guidé dans l'intervalle (A).

**26.** Dispositif (1) selon l'une quelconque des revendications 15 à 25, **caractérisé en ce qu'**un capteur de température est attribué à chaque élément chauffant (9) afin de mesurer sa température, et **en ce qu'**au moins un régulateur PID est prévu, connecté aux éléments chauffants (9) et aux capteurs de température attribués.

**27.** Dispositif (1) selon la revendication 26, **caractérisé en ce qu'**un régulateur PID est prévu pour chaque élément chauffant (9).

**28.** Dispositif (1) selon la revendication 26 ou 27, **caractérisé en ce que** le module de commande de processus est connecté au ou aux régulateurs PID, et établit, conformément à une répartition de température sur la surface du substrat opposée à la plaque chauffante (4), des valeurs de température souhaitées pour les éléments chauffants (9) individuels et communique celles-ci aux régulateurs PID.

**29.** Dispositif selon l'une quelconque des revendications 15 à 28, **caractérisé en ce que** le dispositif (34) pour guider du gaz dans l'intervalle (A) est situé au centre en-dessous de la plaque chauffante.

**30.** Dispositif selon l'une quelconque des revendications 15 à 29, **caractérisé en ce que** le dispositif (34) destiné à guider le gaz dans l'intervalle (A) est un dispositif d'aspiration.

**31.** Dispositif selon l'une quelconque des revendications 15 à 29, **caractérisé en ce que** le dispositif (34) destiné à guider le gaz dans l'intervalle (A) comporte un module de commande afin de régler la quantité et/ou la température du gaz guidé dans l'intervalle.

**32.** Dispositif selon l'une quelconque des revendications 15 à 30, **caractérisé par** un dispositif destiné à la mesure spécifique à l'emplacement d'une largeur de structure, en particulier d'une largeur de structure de laque, sur la surface d'un substrat.

FIG. 1

FIG. 2

FIG. 3

FIG. 4

Durchschnittstemperatur T(t)

FIG. 5

Temperaturabweichung ΔT(t)

FIG. 6

START: ~40
Uniformes Heizprogramm=
Homogene Temperaturverteilung auf der Heizplatte

Temperaturmessung ~42
auf dem Substrat

44
$\sigma \lessgtr \sigma_{max}$ — Nein → Neuberechnung ~48
des Heizprogramms

Ja

ENDE: ~46
Optimiertes Heizprogramm=
Homogene Temperaturverteilung auf dem Substrat

FIG. 7

C

START: ~40
Optimiertes Heizprogramm=
Homogene Temperaturverteilung auf dem Substrat

52
Berechnung des
Temperaturprofils

Temperaturmessung ~42
auf dem Substrat

Optische Messung der
Lackstrukturbreite
auf dem Substrat

44
$\sigma^P < \sigma^P_{max}$ — False → Neuberechnung 48
des Heizprogramms

50

True

ENDE: ~46
Optimiertes Heizprogramm=
Temperaturprofil auf dem Substrat

FIG. 8

| Schritt | Zeit (sec) | ZONE 1 | ZONE 2 | | ZONE 24 | ZONE 25 | Lüfterdrehzahl |
|---|---|---|---|---|---|---|---|
| 1 | 0 | 97.47 | 97.47 | • | 110.27 | 110.27 | 12000 |
| 2 | 20 | 99.35 | 99.35 | • | 111.15 | 111.15 | 5000 |
| 3 | 20 | 103.72 | 103.72 | • | 114.69 | 114.69 | 2000 |
| 4 | 20 | 113.77 | 113.77 | • | 122.32 | 122.32 | 2000 |
| 5 | 20 | 119.1 | 119.1 | • | 125.83 | 125.83 | 2000 |
| 6 | 20 | 123.96 | 123.96 | • | 129.8 | 129.8 | 2000 |
| 7 | 20 | 126.59 | 126.59 | • | 132.17 | 132.17 | 2000 |
| 8 | 20 | 129.03 | 129.03 | • | 134.16 | 134.16 | 2000 |
| 9 | 20 | 131.32 | 131.32 | • | 135.5 | 135.5 | 2000 |
| 10 | 20 | 133.03 | 133.03 | • | 136.68 | 136.68 | 2000 |
| 11 | 30 | 134.63 | 134.63 | • | 137.68 | 137.68 | 2000 |
| 12 | 30 | 135.88 | 135.88 | • | 138.22 | 138.22 | 2000 |
| 13 | 30 | 136.4 | 136.4 | • | 138.58 | 138.58 | 2000 |
| 14 | 30 | 136.35 | 136.35 | • | 139.22 | 139.22 | 2000 |
| 15 | 30 | 138.39 | 138.39 | • | 141.39 | 141.39 | 2000 |
| 16 | 30 | 137.52 | 137.52 | • | 140.07 | 140.07 | 2000 |
| 17 | 30 | 137.6 | 137.6 | • | 140.03 | 140.03 | 2000 |
| 18 | 30 | 137.89 | 137.89 | • | 140.39 | 140.39 | 2000 |
| 19 | 30 | 137.93 | 137.93 | • | 140.47 | 140.47 | 2000 |
| 20 | 30 | 137.96 | 137.96 | • | 140.45 | 140.45 | 2000 |
| 21 | 30 | 137.88 | 137.88 | • | 140.39 | 140.39 | 2000 |
| 22 | 30 | 137.82 | 137.82 | • | 140.36 | 140.36 | 2000 |
| 23 | 30 | 137.83 | 137.83 | • | 140.28 | 140.28 | 2000 |
| 24 | 30 | 137.85 | 137.85 | • | 140.35 | 140.35 | 2000 |
| 25 | 0 | 97.47 | 97.47 | • | 110.27 | 110.27 | 5000 |

FIG. 9

FIG. 10

FIG. 11

FIG. 12

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10059665 C1
- DE 19907497 C
- DE 19907497 C2
- US 6235439 B